# EUROPEAN PATENT APPLICATION

(11) **EP 2 808 901 A1**
(43) Date of publication of application: **03.12.2014**
(21) Application number: 14161620.1
(22) Date of filing: 25.03.2014
(51) Int. Cl.: H01L 31/032, H01L 31/18

(54) **Solar cell and method of manufacturing same**

(30) Priority: 30.05.2013 KR 20130062051
(71) Applicant: Samsung SDI Co., Ltd., Yongin-si, Gyeonggi-do (KR)
(72) Inventor: Jung, Soon-Il, Gyeonggi-do (KR); Ryu, Jeong-Hoon, Gyeonggi-do (KR)
(74) Representative: Taor, Simon Edward William

(57) **Abstract**

A method of manufacturing a solar cell that includes forming a first electrode on a substrate, forming a first thin film including a Group III-VI compound on the first electrode, forming a second thin film including a Group I-III compound on the first thin film, forming a third thin film including a Group III element on the second thin film, heat-treating the first thin film, the second thin film, and the third thin film under a gas atmosphere containing a Group VI element to form a photoactive layer, and forming a second electrode on the resulting photoactive layer, wherein the first thin film and the third thin film include the same Group III element, and the second thin film includes a Group III element that is different from the Group III element of the first thin film and the third thin film.

## Description

A solar cell and a method of manufacturing the same are disclosed.

A solar cell is a photoelectric conversion device that transforms solar energy into electrical energy, and has attracted much attention as an infinite but pollution-free next generation energy source.

A solar cell includes p-type and n-type semiconductors and produces electrical energy by transferring electrons and holes to the n-type and p-type semiconductors, respectively, and then collecting electrons and holes in each electrode, when an electron-hole pair (EHP) is produced by solar light energy absorbed in a photoactive layer inside the semiconductors.

The photoactive layer may include a compound semiconductor including a Group I-III-VI compound including a Group I element, a Group III element and a Group VI element. The compound semiconductor may have a high extinction coefficient and electric/optical stability and the resulting solar cell may have high efficiency. In this context, the Group I element is a transition metal, such as Copper.

However, the compound semiconductor may generate a high ratio difference among elements inside, and on a photoactive layer, due to a reactivity difference among the elements. Herein, the photoactive layer may be formed as a thin film having various compositions of the elements, depending on a location, and thus, may deteriorate efficiency of the solar cell.

One or more aspects of the embodiments of the present invention provide a method of manufacturing a solar cell capable of improving efficiency due to having a photoactive layer of a uniform distribution.

An embodiment of the present invention provides a solar cell manufactured using the method.

According to one embodiment, a method of manufacturing a solar cell includes forming a first electrode, forming a first thin film including a Group III-VI compound on the first electrode, forming a second thin film including a Group I-III compound on the first thin film, forming a third thin film including a Group III element on the second thin film, heat-treating the first thin film, the second thin film, and the third thin film in a gas atmosphere containing a Group VI element to form a photoactive layer, and forming a second electrode on the resulting photoactive layer. In this specification, the term "Group III-VI compound" refers to a compound with a Group III element and a Group VI element, and the "Group I-III compound" refers to a compound with a Group I element and a Group III element. According to an embodiment of the present invention, the first thin film and the third thin film include the same Group III element, and the second thin film includes a Group III element different from the Group III element of the first thin film and the third thin film.

The Group III element of the first thin film and the third thin film may have higher reactivity with the gas atmosphere containing the Group VI element than the Group III element of the second thin film.

The Group III element of the first thin film and the third thin film may be indium (In), and the Group III element of the second thin film may be gallium (Ga).

The Group VI element of the first thin film may be the same as the Group VI element of the gas atmosphere containing the Group VI element.

The Group VI element may include selenium (Se), tellurium (Te), sulfur (S) or a combination thereof.

The Group I element of the second thin film may include copper (Cu), silver (Ag), gold (Au) or a combination thereof.

The first thin film, the second thin film, and the third thin film may be formed using deposition or sputtering.

The gas atmosphere containing the Group VI element may be supplied at a temperature of about 400°C to about 600°C.

The first thin film may be formed with a thickness of about 50 nm to about 100 nm.

The Group III element and the Group VI element of the first thin film may be included in an atomic ratio from about 0.66:1 to about 1:1.

The Group III-VI compound of the first thin film may include InSe, In₂Se₃, or a combination thereof, the Group I-III compound of the second thin film may include CuGa, the Group III element of the third thin film may include In, and the gas atmosphere containing the Group VI element may include a Se-containing gas.

During the heat-treating process, the Group III-VI compound of the first thin film, the Group I-III compound of the second thin film, and the Group III element of the third thin film may react with each other to form a photoactive layer including a Group I-III-VI compound.

The photoactive layer may have a composition of CuInₓGa₁₋ₓSe (0.1≤5x≤50.9).

The photoactive layer may have a substantially single phase.

According to some embodiments, a solar cell is manufactured according to the method as described herein.

The photoactive layer having a uniform distribution may improve efficiency of the solar cell.

According to an aspect of the present invention, there is provided a method of manufacturing a solar cell as set out in claim 1. Preferred features of this aspect are set out in claims 2 to 14.

According to an aspect of the present invention, there is provided a solar cell as set out in claim 15.

The accompanying drawings, together with the specification, illustrate embodiments of the present invention, and, together with the description, serve to explain the principles of the present invention.
FIGS. 1 to 4 are cross-sectional views showing a method of manufacturing a solar cell according to one or more embodiments of the present invention,
FIG. 5 is a SEM photograph showing cross-sections of the photoactive layers of the solar cells manufactured according to Examples 1 and 2 and Comparative Example 1,
FIG. 6 is an XRD graph of the photoactive layers of the solar cells manufactured according to Examples 1 and 2 and Comparative Example 1, and
FIG. 7 is a SIMS graph showing gallium (Ga) distribution depending on depths of the photoactive layers of the solar cells manufactured according to Examples 1 and 2 and Comparative Example 1.

Hereinafter, exemplary embodiments will be described in detail so that a person skilled in the art would understand. However, this disclosure may be embodied in many different forms and is not construed as limited to the exemplary embodiments set forth herein.

In the drawings, the thickness of layers, films, panels, regions, etc., may be exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Further, the use of "may" when describing embodiments of the present invention refers to "one or more embodiments of the present invention."

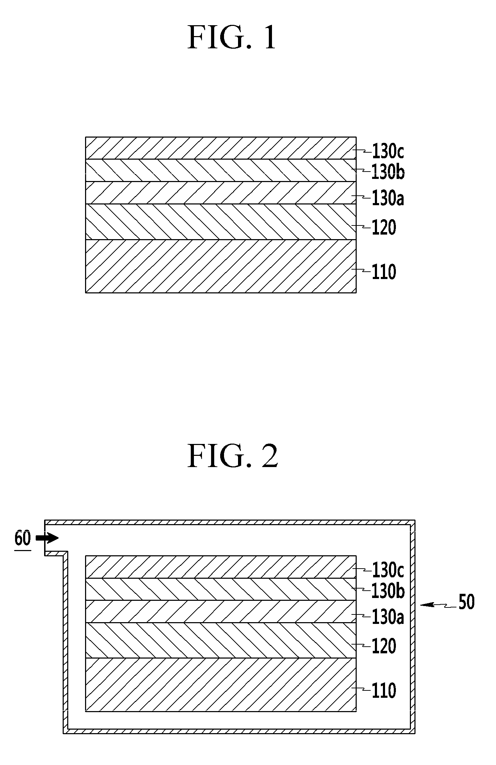

FIGS. 1 to 4 are cross-sectional views illustrating a method of manufacturing a solar cell according to one or more embodiments of the present invention.

Referring to FIG. 1, a lower electrode 120 is formed on a substrate 110.

The substrate 110 may be, for example, a glass substrate, a ceramic substrate, a metal plate, a semiconductor substrate, or a polymer substrate, but is not limited thereto.

The lower electrode 120 may be made of a conductive material, for example molybdenum (Mo), tungsten (W), chromium (Cr), aluminum (Al), silicon (Si), metal silicide, or an alloy thereof.

Subsequently, a first thin film 130a including a Group III-VI compound, a second thin film 130b including a Group I-III compound, and a third thin film 130c including a Group III element are sequentially formed on the lower electrode 120. The first thin film 130a, the second thin film 130b, and the third thin film 130c may be formed using, for example, deposition or sputtering. In some embodiments, the first thin film 130a, the second thin film 130b, and the third thin film 130c are precursor thin films for forming a photoactive layer.

In this context, the Group I element is a transition metal. The Group I element may be, for example, copper (Cu), silver (Ag), gold (Au), or a combination thereof, the Group III element may be, for example, indium (In), gallium (Ga), aluminum (Al), or a combination thereof, and the Group VI element may be, for example, selenium (Se), tellurium (Te), sulfur (S), or a combination thereof.

The Group III elements of the first thin film 130a and the third thin film 130c may be the same, and the Group III element of the second thin film 130b may be different from the Group III element of the first thin film 130a and the third thin film 130c. Herein, the Group III element of the first thin film 130a and the third thin film 130c may have higher reactivity with the gas atmosphere containing the Group VI element than the Group III element of the second thin film 130b. For example, Group III element of the first thin film 130a and the third thin film 130c may be indium (In), and the Group III element of the second thin film 130b may be gallium (Ga).

Embodiments of the present invention provide for three precursor thin films for forming the photoactive layer, which collectively include two kinds of Group III elements. The Group III element having relatively low reactivity with the gas atmosphere containing the Group VI element is included in the second (middle) thin film, and the Group III element having relatively high reactivity with the gas atmosphere containing the Group VI element is included in the first and the third thin films positioned on both sides of the second thin film. Accordingly, both the relatively high reactivity Group III element of the first and the third thin films and the relatively low reactivity Group III element of the second thin film are substantially uniformly distributed within the resulting photoactive layer. In some embodiments, the resulting photoactive layer may have a substantially uniform composition and a crystalline structure having a large grain size.

In contrast, when only two precursor thin films are present with the Group III element having relatively high reactivity with the gas atmosphere containing the Group VI element included in one thin film and the Group III element having relatively low reactivity with the gas atmosphere containing the Group VI element included in the other thin film, the relatively high reactivity Group III element is mostly located on the surface of the resulting photoactive layer, while the relatively low reactivity Group III element is mostly located toward the lower electrode, thus generating undesirable phase separation.

In some embodiments of the present invention, the Group III-VI compound of the first thin film 130a may include the Group III element and the Group VI element in an atomic ratio of about 0.66:1 to about 1:1, and may include, for example InSe, In₂Se₃, or a combination thereof.

The first thin film 130a may be formed with a thickness of about 50 nm to about 100 nm. When the first thin film 130a has a thickness within this range, the Group III element having relatively low reactivity with the gas atmosphere containing the Group VI element and the Group III element having relatively high reactivity with the gas atmosphere containing the Group VI element may form a compound semiconductor having a substantially uniform composition over a photoactive layer.

The Group I-III compound of the second thin film 130b may include, for example, CuGa, and the Group III element of the third thin film 130c may include, for example, In. The second thin film 130b and the third thin film 130c each may be formed with a thickness of about 300 nm to about 500 nm and, in some embodiments, each may be formed with a thickness about 200 nm to about 400 nm.

Referring to FIG. 2, the substrate 110, on which the lower electrode 120, the first thin film 130a, the second thin film 130b, and the third thin film 130c are stacked, is disposed in a chamber 50, and then heat-treated while supplying a gas atmosphere containing the Group VI element 60 into the chamber, according to some embodiments of the present invention. The heat-treating process may be performed at about 400°C to about 600°C for about 30 minutes to about 120 minutes.

The Group VI element of the first thin film 130a may be the same as the Group VI element of the gas atmosphere containing the Group VI element 60, and may include, for example, selenium (Se), tellurium (Te), sulfur (S), or a combination thereof. In another embodiment, the Group VI element may be selenium (Se). When the Group VI element is selenium (Se), the gas atmosphere containing the Group VI element 60 may be, for example, H₂Se.

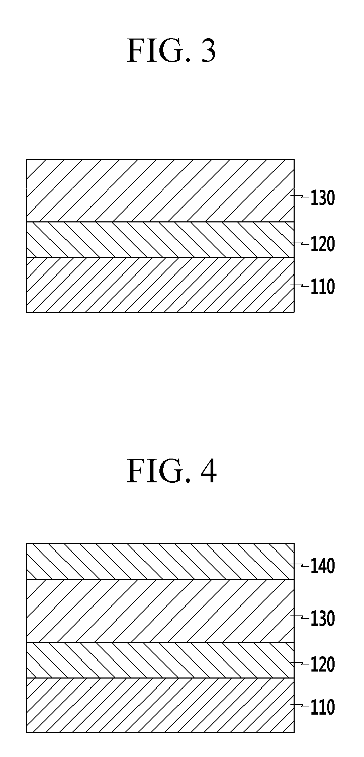

Referring to FIG. 3, during the heat-treating process, the Group III-VI compound of the first thin film 130a, the Group I-III compound of the second thin film 130b, and the Group III element of the third thin film 130c may react with each other to form a photoactive layer 130 including a Group I-III-VI compound.

The photoactive layer 130 may be a compound semiconductor including a Group I element, two kinds of Group III elements, and a Group VI element, for example, a compound semiconductor having a composition of CuInₓGa₁₋ₓSe (0.1≤x≤0.9). When the compound semiconductor has a substantially uniform composition, the photoactive layer 130 may have a single phase.

Referring to FIG. 4, an upper electrode 140 may be formed on the photoactive layer 130. The upper electrode 140 may be a transparent electrode, and may be made of ZnO or Indium Tin Oxide (ITO), but embodiments of the invention are not limited thereto.

Hereinafter, the above-described aspects of the present disclosure are illustrated in more detail with reference to examples. However, it shall be understood that these examples are only used to specifically set forth the present disclosure, and they are not provided to be limiting in any form.

### Manufacture of a Solar Cell

### Example 1

A 400 nm-thick molybdenum (Mo) electrode was sputtered on a glass substrate, and then, a 50 nm-thick InSe thin film, a 320 nm-thick CuGa thin film, and a 295 nm-thick In thin film were sequentially deposited on the molybdenum (Mo) electrode. Subsequently, the resulting glass substrate was disposed in a quartz chamber and heat-treated at 450°C for 30 minutes, while H₂Se was supplied into the chamber with a flow rate of 1 sccm, forming a photoactive layer having a composition of CuIn_{0.6}Ga_{0.4}Se toward the lower electrode, and a composition of CuIn_{0.85}Ga_{0.15}Se at the outer surface of the photoactive layer. Then, the glass substrate was taken out of the quartz chamber, and a 1000 nm-thick ZnO electrode was sputtered on the photoactive layer, manufacturing a solar cell.

### Example 2

A solar cell was manufactured according to the same method as described in Example 1 except a photoactive layer having a composition of CuIn_{0.7}Ga_{0.3}Se was formed by using a 100 nm-thick InSe thin film instead of the 50 nm-thick InSe thin film.

### Comparative Example 1

A solar cell was manufactured according to the same method as described in Example 1 except a photoactive layer having a composition of CuIn_{0.5}Ga_{0.5}Se toward the lower electrode, and a composition of CuInSe at the outer surface of the photoactive layer, was formed by using only the CuGa thin film and the In thin film, but no InSe thin film.

### Evaluation 1

The cross-section of each photoactive layer used in the solar cells manufactured according to Examples 1 and 2 and Comparative Example 1 were examined by using SEM, and grain sizes thereof were compared.

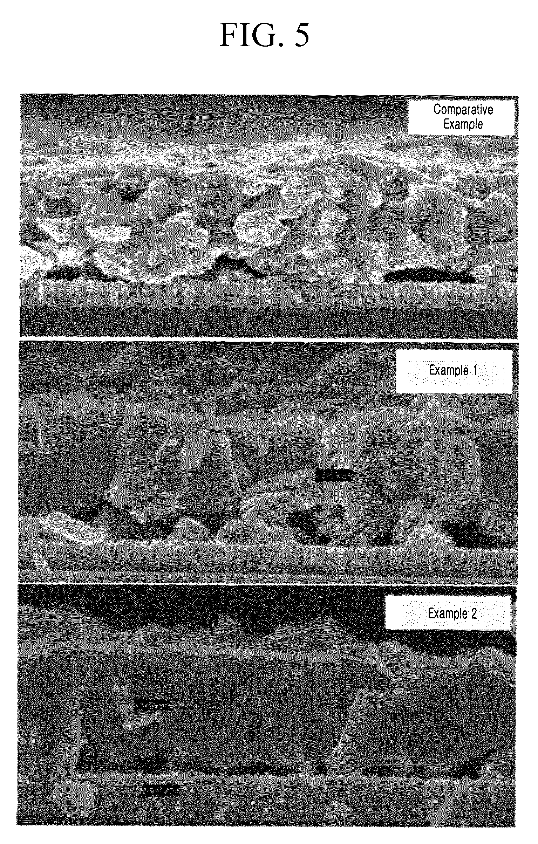

FIG. 5 is a SEM photograph showing cross-sections of photoactive layers of the solar cells according to Examples 1 and 2 and Comparative Example 1.

Referring to FIG. 5, the solar cells according to Examples 1 and 2 showed a larger grain size than the solar cell according to Comparative Example 1. The solar cells according to Examples 1 and 2 showed increased open-circuit voltage and thus, improved efficiency, compared to the solar cell according to Comparative Example 1.

### Evaluation 2

The crystallinity of the photoactive layers used in the solar cells manufactured according to Examples 1 and 2 and Comparative Example 1 was compared.

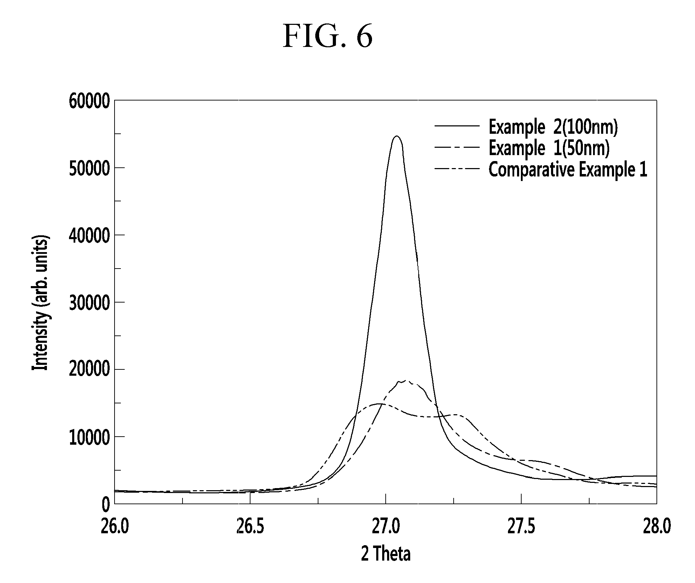

FIG. 6 is an XRD graph of intensity vs. the angle of 2-Theta of the photoactive layers of the solar cells manufactured according to Examples 1 and 2 and Comparative Example 1.

As shown by the graph illustrated in FIG. 6, the solar cells according to Examples 1 and 2 showed a substantially single-phase crystalline structure, while the solar cell according to Comparative Example 1 showed a phase separation.

### Evaluation 3

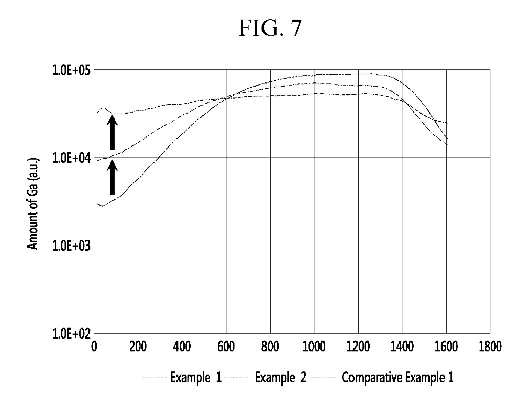

In the photoactive layers of the solar cells manufactured according to Examples 1 and 2 and Comparative Example 1, the distribution amounts of gallium (Ga) depending on a depth of a photoactive layer were evaluated. The distribution amounts of gallium (Ga) were evaluated using a SIMS method and the results are provided in FIG. 7.

FIG. 7 is a graph of gallium (Ga) distribution vs. depths of photoactive layers of the solar cells according to Examples 1 and 2 and Comparative Example 1.

In FIG. 7, '0' of the horizontal axis indicates the surface of the photoactive layer.

As shown by the graph illustrated in FIG. 7, the solar cells according to Examples 1 and 2 show generally more uniform gallium (Ga) distribution compared to the solar cell according to Comparative Example 1.

### Evaluation 4

Efficiency of the solar cells manufactured according to Examples 1 and 2 and Comparative Example 1 was compared.

The results are provided in Table 1.

**Table 1**

| | Open-circuit voltage (Voc) | Open-circuit current density (Jsc) (mA/cm²) | Fill factor (FF) (%) | Efficiency (%) |
|---|---|---|---|---|
| Example 1 | 0.649 | 33.8 | 73 | 15.97 |
| Example 2 | 0.669 | 32.9 | 74 | 16.38 |
| Comparative Example 1 | 0.618 | 35.2 | 70 | 15.26 |

Referring to Table 1, the solar cells according to Examples 1 and 2 showed improved efficiency compared to the solar cell according to Comparative Example 1. Embodiments of the invention provide a method of manufacturing a solar cell, comprising: forming a first electrode, forming a first thin film comprising a Group III-VI compound comprising a first Group III element and a first Group VI element on the first electrode, forming a second thin film comprising a Group I-III compound comprising a Group I element and a second Group III element that is different from the first Group III element on the first thin film, forming a third thin film comprising the first Group III element on the second thin film, heat-treating the first thin film, the second thin film, and the third thin film under a gas atmosphere containing a second Group VI element that is the same or different from the first Group VI element to form a photoactive layer, and forming a second electrode on the photoactive layer.

In some embodiments, the first Group III element may have a higher reactivity with the second Group VI element than the second Group III element. In some embodiments, the first Group III element is indium (In), and the second Group III element is gallium (Ga). In some embodiments, the first Group VI element and the second Group VI element are the same. In some embodiments, the first and/or second Group VI element is selected from the group consisting of selenium (Se), tellurium (Te), sulfur (S) and combinations thereof. In some embodiments, the Group I element is a transition metal selected from the group consisting of copper (Cu), silver (Ag), gold (Au), and combinations thereof. In some embodiments, the photoactive layer comprises a Group I-III-VI compound.

Embodiments of the invention also provide a solar cell manufactured by any of the above methods.

Embodiments of the invention can provide a solar cell having a first electrode, a photoactive layer on the first electrode, and a second electrode on the photoactive layer, wherein the photoactive layer comprises a Group I-III-VI compound having a single phase. In some embodiments, the photoactive layer comprises CuInₓGa₁₋ₓSe, wherein 0.1≤x≤0.9.

While this disclosure has been described in connection with what is presently considered to be practical exemplary embodiments, it is to be understood that the invention is not limited to the disclosed embodiments, but, on the contrary, is intended to cover various modifications and equivalent arrangements included within the scope of the appended claims and equivalents thereof.

## Claims

1. A method of manufacturing a solar cell, comprising:
forming a first electrode,
forming a first thin film comprising a Group III-VI compound comprising a first Group III element and a first Group VI element on the first electrode,
forming a second thin film comprising a Group I-III compound comprising a Group I element and a second Group III element that is different from the first Group III element on the first thin film,
forming a third thin film comprising the first Group III element on the second thin film,
heat-treating the first thin film, the second thin film, and the third thin film under a gas atmosphere containing a second Group VI element that is the same or different from the first Group VI element to form a photoactive layer, and
forming a second electrode on the photoactive layer.

2. The method of claim 1, wherein the first Group III element has a higher reactivity with the second Group VI element than the second Group III element.

3. The method of claim 1 or 2, wherein the first Group III element is indium (In), and the second Group III element is gallium (Ga).

4. The method of any one of claims 1 to 3, wherein the first Group VI element and the second Group VI element are the same.

5. The method of any one of claims 1 to 4, wherein the first and/or second Group VI element is selected from the group consisting of selenium (Se), tellurium (Te), sulfur (S) and combinations thereof.

6. The method of any one of claims 1 to 5, wherein the Group I element is selected from the group consisting of copper (Cu), silver (Ag), gold (Au), and combinations thereof.

7. The method of any one of claims 1 to 6, wherein the first thin film, the second thin film, and the third thin film are formed using deposition or sputtering.

8. The method of any one of claims 1 to 7, wherein the gas atmosphere containing the second Group VI element is supplied at a temperature of about 400°C to about 600°C.

9. The method of any one of claims 1 to 8, wherein the first thin film is formed with a thickness of about 50 nm to about 100 nm.

10. The method of any one of claims 1 to 9, wherein the first Group III element and the first Group VI element are included in an atomic ratio of about 0.66:1 to about 1:1.

11. The method of any one of claims 1 to 10, wherein
the Group III-VI compound of the first thin film is selected from the group consisting of InSe, In₂Se₃, and combinations thereof,
the Group I-III compound of the second thin film comprises CuGa,
the Group III element of the third thin film is In, and
the gas atmosphere containing the second Group VI element comprises a Se-containing compound.

12. The method of any one of claims 1 to 11, wherein the photoactive layer comprises a Group I-III-VI compound.

13. The method of claim 12, wherein the photoactive layer comprises CuInₓGa₁₋ₓSe, wherein 0.1≤x≤0.9.

14. The method of claim 12 or 13, wherein the photoactive layer has a single phase.

15. A solar cell manufactured according to any one of claims 1 to 14.
